(19)

Europäisches Patentamt
European Patent Office
Office européen des brevets

(11) **EP 2 243 847 A1**

(12) **EUROPEAN PATENT APPLICATION**
published in accordance with Art. 153(4) EPC

(43) Date of publication:
**27.10.2010 Bulletin 2010/43**

(21) Application number: **09708058.4**

(22) Date of filing: **06.02.2009**

(51) Int Cl.:
**C22C 9/06** (2006.01)    **C22F 1/08** (2006.01)
**H01B 1/02** (2006.01)    **C22F 1/00** (2006.01)
**H01L 23/50** (2006.01)

(86) International application number:
**PCT/JP2009/052082**

(87) International publication number:
**WO 2009/099198 (13.08.2009 Gazette 2009/33)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **08.02.2008   JP 2008029778**

(71) Applicant: **The Furukawa Electric Co., Ltd.**
**Chiyoda-ku**
**Tokyo 100-8322 (JP)**

(72) Inventors:
• **MIHARA, Kuniteru**
  **Tokyo 100-8322 (JP)**
• **KANEKO, Hiroshi**
  **Tokyo 100-8322 (JP)**
• **HIROSE, Kiyoshige**
  **Tokyo 100-8322 (JP)**

(74) Representative: **Forstmeyer, Dietmar et al**
**BOETERS & LIECK**
**Oberanger 32**
**80331 München (DE)**

(54) **COPPER ALLOY MATERIAL FOR ELECTRIC AND ELECTRONIC COMPONENTS**

(57)    A copper alloy material for electric/electronic components according to the present invention is **characterized in that** a average grain size of 1 to 50 $\mu$m that is designated by $((a+b)/2)$ in which a thickness of a grain is defined to be (a) and a width thereof is defined to be (b) which is on a cross section that is vertical to a rolling direction, an aspect ratio $(a/b)$ thereof is between 0.5 and 1.0, an aspect ratio $(a/b)$ of a grain before performing a bend working and an aspect ratio $(a'/b')$ of which a grain is effected by a tensile stress after performing a bend working of 90 degrees satisfy the following (Formula 1) of:

$$2 \leq (a+b)/(a'/b') \leq 15 \qquad \text{(Formula 1)},$$

and the copper alloy material has a bending workability to be excellent.

Fig. 1

SHEET BEFORE BENDING TEST
ROLLING DIRECTION
BENDING TEST PIECE
1
a
b

EP 2 243 847 A1

**Description**

Technical Field

The present invention relates to a copper alloy material which is to be applied to electric/electronic components.

Background Art

Conventionally, as a material for such as a connector and a terminal for a usage of an electric apparatus and of an electronic equipment, for a relay, for a switch, or the like, a copper alloy (such as a phosphor bronze or a brass, or the like) is made use as widely, which is superior in electrical conduction property and in thermal conduction property. However, with being accompanied by a packaging in size to be smaller and by being lightened of the electrical apparatus and of the electronic equipment, a part and component which is to be mounted thereon becomes to be mounted in high density. And hence various kinds of properties are required as well for a copper alloy material that is to be made use for these. For example, for the copper alloy to be made use a material becomes to be made use which has a thickness to be thinner with being accompanied by the packaging in size to be smaller and by being lightened of the part and component. And then the thinner a material is, the stronger a strength (the higher a hardness) for the material becomes to be required in order to obtain a contact pressure load which is similar to the conventional. In the meantime however, in a case where the strength of a general metallic material becomes to be improved an elongation becomes to be decreased and also a bending workability becomes to be deteriorated, that are heretofore known. Moreover, regarding this bending workability a matter is required of which a material should be bended with having a bend radius to be further smaller (a further severe bend working), that is accompanied by the packaging in size to be smaller of the electric/electronic components.

Further, in order to satisfy the properties of the strength and the bending workability that are conflicted to each other it is regarded that in a case where a method for improving the strength by making use of a precipitation hardening is applied to a copper alloy among a variety of method for hardening, such as a solution heat hardening, a work hardening, the precipitation hardening, or the like, it becomes difficult for the bending workability to be deteriorated. And then among those an alloy that is called a Corson alloy has an ability for hardening to be higher as extremely among a plurality of alloys of a precipitation type, for which Ni and Si are added into Cu and a precipitate is to be formed which is comprised of the Ni and the Si and then the same is to be hardened. And hence the same is made use for some alloys on the market, such as the CDA70250 which is the registered alloy of Copper Development Association (CDA) or the like.

And then there are many examples that are heretofore known in which there are described regarding such as the strength, a grain size, the bending workability, or the like of this Corson alloy.

For example, there is disclosed the specification of the grain size in the following patent document 1. In the meantime however, there is not disclosed any specification regarding a size of the precipitates and a space of those. Moreover, there is not disclosed any description at all regarding a variation of a grain after performing a bend working.

And in the meantime, an objective of the patent document 2 is regarding a stress relaxation resistance. Moreover, a compression of a grain size of a final product is specified, in the meantime however, there is not disclosed any description at all regarding a variation of a grain size after performing a bend working. And in the meantime, an application of the patent document 3 is to a lead frame, in the meantime however, there is not clarified at all regarding such as a lower limit of a grain size or a lower limit of a size of a precipitate or the like. Moreover, there is not disclosed any description at all regarding a variation of a grain size before and after performing a bend working.

And in the meantime, in accordance with the following patent document 4 there are disclosed the descriptions regarding the average grain size and the bending workability, in the meantime however, there is not disclosed any description at all regarding a specification of a distortion of a grain nor of a precipitate after performing a bend working. And in the meantime, in accordance with the patent document 5 there is disclosed the description of a stamping property regarding the average grain size, in the meantime however, there is not disclosed any description at all regarding a bending workability.

And in the meantime, in accordance with the patent document 6 there is disclosed the description rewarding the grain size, in the meantime however, there is not disclosed any description at all regarding a size of a precipitate nor a bending workability. And in the meantime, in accordance with the patent document 7 there is disclosed the description of containing phosphorus (P) with a variety of the indispensable elements and of the grain size, in the meantime however, there is not disclosed any description at all regarding a bending workability.

And in the meantime, in accordance with the following patent document 8 and the patent document 9 there is disclosed the description regarding the grain size, in the meantime however, there is not disclosed any description at all regarding a size of a precipitate nor a bending workability. And in the meantime, in accordance with the patent document 10 there is disclosed the description regarding the relation between the grain size and the inclusion after performing the final rolling, in the meantime however, there is not disclosed any description at all regarding a matter after performing a bend working.

And thus not only in accordance with these heretofore known patent documents but there cannot be found any heretofore known examples in which a variation in shape of a grain size before and after performing a bend working is examined in detail. And then in accordance with the examples therein there is disclosed the description regarding the matter having good and bad points of the strength, of the grain size and of the bending workability as simply. In the meantime however, there cannot be found any documents at all in which a distortion action (an aspect ratio) of a grain size is paid attention.

Here, the bend working is specified in the JIS-Z2248: 2006 of Japanese Industrial Standards: "Metallic materials - Bend test". Moreover, a test method of a (W) bending with a bend angle of 90 degrees is described as well in the JBMA-T307 (1999) in accordance with the technical standards of Copper Elongation Society of Japan: "Standard test method of bend formability for sheets and strips of copper and copper alloys". And then the evaluation of these is performed in general. Further, good and bad points of this bending workability are judged by performing an evaluation whether or not occurring any crack by performing an observation of a top part of a test piece which is bended with a variety of bend radiuses.

For example, in a case where the (W) bending is performed with the bending angle of 90 degrees stresses of two different types become to be occurred that are a tensile stress and a compressive stress at a surface layer part which is bended on a material (a top surface in a direction of a sheet thickness of a sheet). Still further, it is heretofore known that the tensile stress functions toward an outer face side of a material which is bended, on the contrary however, that the compressive stress functions toward an inner face side of the material. And then it is regarded that a crack becomes to be occurred in the material because this tensile stress becomes to be localized at the top of the bended part.

Still further, it is able to avoid the crack if a grain in a part where the tensile stress functions becomes to be distorted in a direction of which a force functions. In the meantime however, in a case where it is not able to perform the distortion of the same the crack becomes to be started occurring from such as a crystalline grain boundary or an inside of the grain or the like. That is to say, in order to prevent from the occurrence of the crack a distortion is required as uniformly in a direction for a grain to be functioned by the force.

Still further, a grain in a copper alloy which is to be bend working does not have a shape as isometrically (which is equivalent as isotropically) in general, but the same is distorted (oblate) as slightly because the same is performed a working of such as a rolling or the like. Furthermore, the distortion (oblateness) becomes to be progressed by being performed the bend working in addition thereto.

[Patent Document 1] Japanese Patent Application Publication No. 2002-180161
[Patent Document 2] Japanese Patent Application Publication No. H11-293367
[Patent Document 3] Japanese Patent Application Publication No. H10-110228
[Patent Document 4] Japanese Patent Application Publication No. H03-162553
[Patent Document 5] Japanese Patent Application Publication No. H05-279825
[Patent Document 6] Japanese Patent Application Publication No. H11-335756
[Patent Document 7] Japanese Patent Application Publication No. H07-018356
[Patent Document 8] Japanese Patent Application Publication No. H03-162553
[Patent Document 9] Japanese Patent Application Publication No. H03-188247
[Patent Document 10] Japanese Patent Application Publication No. 2005-089843

Disclosure of the Invention

Problems to be Solved by the Invention

As it is described above, it is found out that it is not able to obtain a desired material for a copper alloy of which it is able to withstand a stern bending workability by making use of only the technologies (the specification of such as the crystalline grains size or the hardness or the like) that are disclosed in each of the above mentioned patent documents. Moreover, it is found out that in order to obtain a material which has the strength to be further stronger (the hardness to be higher) and has a stern bending workability it is important to comprehend a variation of a grain size before and after performing a bend working.

And then with having regard to such as the above described problems or the like, a problem to be solved by the present invention is to provide a copper alloy material which has the strength to be stronger (the hardness to be higher), which is superior in the bending workability, and which is to be applied as desirably to electric/electronic components, such as a connector or a terminal material or the like.

Means for Solving the Problem

The present inventors have performed the study regarding the copper alloy material which is to be applied as desirably to the usage of the electric/electronic components. And hence it is found out that the strength (a Vickers hardness) which is to be required is between 180 and 350 of the Hv. And then it is confirmed that in accordance with this hardness it is not able to perform a bend working as easily.

And then therefore a problem to be solved by the present invention is to obtain a copper alloy material which is superior in the bending workability even with having the hardness to be higher. And hence it is found out that it is desirable to have a predetermined relation regarding the grain size before and after performing the bend working, and then further examination is performed. And thus it becomes able to complete the invention.

And then in accordance with the present invention it becomes able to obtain the aspects that will be described in detail below.

(1) A copper alloy material for electric/electronic components,
wherein a average grain size of 1 to 50 μm that is designated by ((a + b) / 2) in which a thickness of a grain is defined to be (a) and a width thereof is defined to be (b) which is on a cross section that is vertical to a rolling direction,
an aspect ratio (a / b) thereof is between 0.5 and 1.0,
an aspect ratio (a / b) of a grain before performing a bend working and an aspect ratio (a' / b') of which a grain is effected by a tensile stress after performing a bend working of 90 degrees satisfy a following (Formula 1):

$$2 \leq (a + b) / (a' / b') \leq 15 \quad (Formula\ 1),$$

and
the copper alloy material has a bending workability to be excellent.
(2) The copper alloy material for electric/electronic components according to aspect 1,
wherein a Vickers hardness (Hv) on a cross section is between 180 and 350, which is vertical to the rolling direction before performing the bend working, and
the copper alloy material has a bending workability to be excellent.
(3) The copper alloy material for electric/electronic components according to aspect 1 or 2, comprising:

Ni and/or Co between 1.0 mass% and 4.5 mass%, respectively;
Si between 0.2 mass% and 1.2 mass%; and a remaining portion which is formed of Cu and an unavoidable impurity.

(4) The copper alloy material for electric/electronic components according to aspect 3,
wherein the copper alloy material further comprises at least one nature between 0. 005 mass% and 1.0 mass%, which is selected from a group that is comprised of Sn, Zn, Cr and Mg.
(5) The copper alloy material for electric/electronic components according to any of aspects 1 to 4,
wherein it becomes able to perform a solution annealed recrystallization heat treatment with a temperature between 700°C and 1000°C before performing a final rolling, and it becomes able to perform a quick cooling with a cooling rate of faster than or equal to 100°C per second.

Here, the aspect ratio in the above described aspect (1) is defined as follows. A grain of an alloy is surrounded by a grain boundary. And then the grain is oblate (distorted) due to a working of such as a rolling or the like. And then therefore a grain size is to be evaluated by performing a measurement of a distance from one side of the grain boundary to the other side of the grain boundary (refer to a method of cutting in accordance with the JIS H 0501).

And in the meantime, in order to perform the measurement of a degree of the oblateness that is mentioned above, it is able to perform an evaluation of the aspect ratio by performing a measurement of a grain size on two of lines that intersect each other with an angle of 90 degrees.

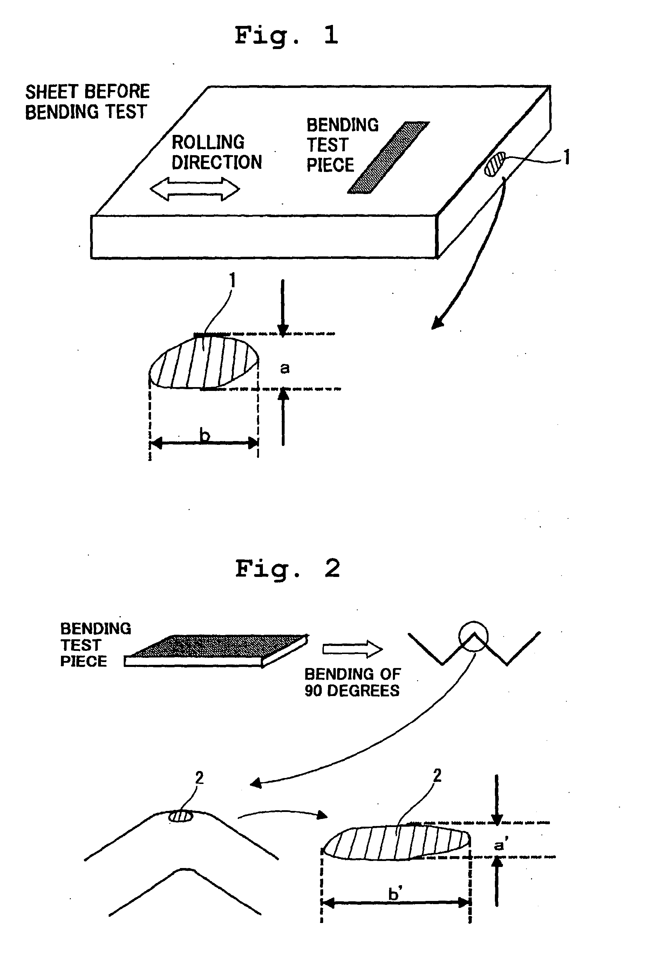

In accordance with the method of performing the measurement of a grain which is to be made use for the present invention it becomes able to perform an observation of a grain boundary to be easier by performing an etching with making use of an aqueous solution of a chromic acid after performing a mechanical polishing and then performing a mirror finish polishing of a texture on a cross section which is vertical to a rolling direction, that is shown in FIG. 1. And then thereafter a taking a photograph is performed as normally by making use of a scanning electron microscope (an SEM) with a magnification between 400 times and 2000 times. And then a distance in two directions of vertical (a) and of parallel (b) to a rolled face, that is to say, "a thickness (a)" and "a width (b)" for each piece of the grains. And then in this case the number of the grains that are to be measured is approximately between 50 pieces and 100 pieces (it may be available for the number of the grains as not so strictly). And then an evaluated value is made use for a average grain size by performing a calculation of ((a + b) / 2).

Moreover, regarding the aspect ratio after performing the bend working a taking of a photograph is performed by making use of the SEM for an upper part to be bended (a cross section of an outside surface layer part) which is effected a tensile stress, after performing the polishing and then performing the etching for the cross section of the bended material by making use of a method that is similar to the above description, as one example is shown in FIG. 2. Further, "the grain which is effected the tensile stress" in accordance with the present invention is defined here to be a grain at a vicinity of the outside surface layer which exists in a range from the outside surface to a depth of approximately 50 μm.

Still further, in this case there is a limitation on the number of the grains at the vicinity of the outside surface layer. And then therefore a distance is to be measured in two directions of vertical (a') and of parallel (b') to a direction of a bending stress, that is to say, "a thickness (a')" and "a width (b')" for each piece of the grains, with the number of the grains approximately between 10 pieces and 20 pieces (it may be available for the number as not so strictly).

And then after performing the measurement, a value of (a / b) and of (a' / b') for each of the grain sizes is designed to be evaluated, and then an average for each of the values is designed to be evaluated.

Still further, in accordance with the present invention a test piece is designed to be produced by performing a cutting out into a dimensions of ten millimeters of a width and of twenty-five millimeters of a length (a thickness is equivalent to the thickness of each of sample sheet materials, respectively), which is vertical to a rolling direction for each of the sample sheet materials, that is shown in FIG. 1. And then thereafter a (W) bending of 90 degrees (Bad-way bending) is performed for each of these bending test piece respectively, for an axis of the bending so as to be parallel to the above mentioned rolling direction, that is shown in FIG. 2. And then thereafter an observation is designed to be performed whether or not exist any crack at a bended part by making use of an optical microscope as a visual observation with a magnification of fifty times. Still further, an observation is designed to be performed whether or not exist any crack at the part for the bend working by making use of the scanning electron microscope (SEM). And hence the bending workability is to be evaluated due to the crack which is to be observed whether or not exist. Furthermore, in accordance with this evaluation it is desirable in accordance with the present invention that there is not occurred any crack at all in a case where a bend radius (R) is equal to 0.2 millimeter for a test piece, though a crack is occurred in a case where the (R) is equal to zero millimeter for the similar test piece. And then it is further preferable in accordance with the present invention that there is not occurred any crack at all in the case where the (R) is equal to zero millimeter.

Effects of the Invention

In accordance with the present invention it becomes able to perform the limitation of the grain size before performing the bend working, and it becomes able to specify the variation of the aspect ratio of the grain before and after performing the bend working due to the distortion of the grain by performing the bend working. And then therefore it becomes able to obtain a copper alloy material which has the strength to be stronger, which is superior in the bending workability, and which is to be applied as preferably to a part and component for the usage of the electric apparatus and of the electronic equipment. Moreover, it becomes able to make use of an alloy of Cu-Ni-Si system or an alloy of Cu-Co-Si system or an alloy of Cu-Ni-Co-Si system for the alloy in accordance with the present invention. Further, it becomes able to obtain the copper alloy material which has the properties to be further superior to others, by performing the further addition of Sn, Zn, Cr and Mg.

Furthermore, it becomes able to obtain the material which has the strength to be further stronger, and it becomes able to obtain the copper alloy material as well which has the bending workability to be superior to others, by performing the solution annealed recrystallization heat treatment at the predetermined temperature, and then by performing the limitation of the cooling rate.

The above and other aspects and advantages according to the present invention will be further clarified by the following description, with reference to the drawings to be attached as properly therefor.

Brief Description of the Drawings

FIG. 1 is an explanatory drawing exemplary showing a location of cutting out a bending test piece and showing an evaluation method of a grain size before performing a bend working.

FIG. 2 is an explanatory drawing showing a direction for a bend working of a test piece and showing an evaluation method of a grain size after performing the bend working.

FIG. 3 is a graph showing one example of a cooling rate by making use of each type of the liquid coolants.

Brief Description of the Reference Symbols

1. GRAIN BEFORE PERFORMING A BEND WORKING
2. GRAIN AFTER PERFORMING THE BEND WORKING

Best Mode for Carrying Out the Invention

A desired embodiment regarding a copper alloy material in accordance with the present invention will be described in detail below.

And regarding the copper alloy material in accordance with the present invention a shape will not be limited at all in particular, however, the same has a shape of such as a sheet material, a bar material, a wire rod, a bar stock, a foil, or the like. And then it is able to make use of the same for any type of the electric/electronic components. Moreover, the part and component will not be limited at all in particular, however, the same can be applied to such as a connector, a terminal material, relay, a switch, a lead frame, or the like, and a connector or a terminal material for such as a usage of being mounted on to a motor vehicle or the like.

Here, the ground of the average grain size of the copper alloy material in accordance with the present invention to be within the range of 1 to 50 $\mu$m is because that in a case where the average grain size is smaller than 1 $\mu$m the calculated average grain size may become to be smaller than 1 $\mu$m in a case where only grains of which it is able to perform the observation of the grain boundary as clearly are extracted, and then that it becomes more difficult to perform a judgment because there are a plurality of grains of which it is not able to perform the observation of the grain boundary as clearly, in the meantime however, that the bending workability becomes to be worsened in a case where the bend working is performed for a mixed grain which contains such a texture. And then therefore the lower limit is set up to be 1 $\mu$m.

And in the meantime, the ground of which the upper limit is set up to be 50 $\mu$m is because that in a case where the average grain size is larger than 50 $\mu$m an area of the grain boundary in the material (sheet) becomes to be smaller, and that the bending workability becomes to be deteriorated because the bending stress at the period of performing the bend working becomes to be localized at less grain boundaries. And then therefore it is desirable for the average grain size to be 2 to 20 $\mu$m, and then it is further preferable for the same to be 3 to 10 $\mu$m.

Moreover, in accordance with the present invention it is desirable for the Vickers hardness (Hv) on a cross section which is vertical to the rolling direction to be between 180 and 350. And the ground to be within this range is because that it is heretofore known that the lower the hardness of a material is, the further excellent the bending workability becomes to be in general, and then that the lower limit is set up to be limited in order to perform an improvement of the bending workability of a material which has the hardness to be relatively harder of which the Hv is higher than or equal to 180 in accordance with the present invention. And in the meantime, the ground of which the upper limit of the Hv is set up to be 350 is because that a phenomenon becomes to be occurred which is called an embrittlement of a grain boundary in a material which has a high hardness that is higher than or equal to this value, and hence that there are some cases of which it is not able to obtain an advantage with a desirable amount of degrees for performing the improvement of the bending workability.

Further, for the copper alloy in accordance with the present invention it may be available to make use of the other copper alloy system if the same is a copper alloy of the precipitation hardened type, such as the Corson alloy or the like. In the meantime however, it is further preferable for a material to comprise the component and the composition that will be described in detail below.

In the first instance, in a case where there is performed a multiple addition of Ni and Co it is desirable for the same to be between 1.0 mass% and 4.5 mass% in total, or it is further preferable for the same to be between 2.2 mass% and 3.5 mass% in total. Moreover, it is desirable for a mass ratio of the same as (Ni / Co) to be between 0.25 mass% and 2.5 mass%, or it is further preferable for the (Ni / Co) to be between 0.25 mass% and 1.25 mass%.

And in the meantime, in a case where Ni is added as singly it is desirable for the same to be between 1.8 mass% and 4.5 mass%, or it is further preferable for the same to be between 2.2 mass% and 3.8 masts%. And in the meantime, in a case where Co is added as singly it is desirable for the same to be between 1.0 mass% and 4.5 mass%, or it is further preferable for the same to be between 1.2 mass% and 1.8 mass%.

Next, it is desirable for Si to be added between 0.2 mass% and 1.2 mass%, or it is preferable for the same to be between 0.3 mass% and 0.9 mass%, and then it is further preferable for the same to be between 0.4 mass% and 0.7 mass%.

And in the meantime, there will not be limited at all in particular regarding the mass ratio between the Ni and the Si or between the Co and the Si or of ((Ni + Co) / Si), however, it is desirable for each to be between 3.5/1 and 5.0/1 respectively.

Furthermore, it is desirable for the copper alloy in accordance with the present invention to contain at least one nature between 0.005 mass% and 1.0 mass% in total, which is to be selected from a group that is comprised of Sn, Zn, Cr and Mg.

Here, Sn and Zn individually have a property of which the same is to be solution heated into a mother phase of copper and then is to harden. And then therefore there is a case where it is not able to obtain this advantage in a case where the amount is less than 0.005 mass% . And in the meantime, there is a case where the electrical conductivity becomes to be prevented in a case where the same is more than 1 mass% . And then therefore the range is set up to be within this amount. Moreover, Zn has a further advantage as well by which it becomes able to perform an improvement of a solder adhesiveness.

In the meantime however, it has not yet specified regarding the advantage of Cr and Mg. In the first instance, there may be sometimes detected these elements in a case where a chemical compound (precipitate) of the Ni-Si system, of the Co-Si system and of the Ni-Co-Si system. And then therefore the same may contribute the precipitation hardening. However, there is not always detected from any of the precipitate. Moreover, it is estimated that a part of any of Mg and Cr becomes to be solution heated and then to contribute the solution heat hardening, however, it is not sure. Further, the above mentioned intermetallic compound becomes to perform a pinning of the grain boundaries, and then it becomes able to obtain the advantage of which the grain becomes to be prevented from growing. Furthermore, it is able to obtain the improvement of the strength as well because of the advantage by which the grain size becomes to be finer.

In the meantime however, in a case where the amount is less than 0.005 mass% there is a case where it is not able to obtain the result of analysis nor the advantages that are individually described above. And in the meantime, in a case where the same is more than 1 mass% there becomes to be existed a plurality of crystallized precipitates in an ingot. And hence there is a case where the hot workability becomes to be prevented. And then therefore it is desirable for the same to be within the above mentioned range.

Moreover, in a case where each of the elements is to be added as singly it is further preferable to be between 0.05 mass% and 0.75 mass% for a total amount in a case of performing a multiple addition.

And in addition to the above mentioned matter, there is not effected as negatively to the electrical conductivity and to the strength even in a case of performing an addition of Fe, Ti, Zr, B, V, P as singly with an amount of less than or equal to 0.1 mass%, or as multiply with an amount of less than or equal to 0.5 mass% in total.

Next, a manufacturing process which is desirable in order to obtain the copper alloy material in accordance with the present invention is embodied by such as the follows or the like. And then a schematic process comprises the following steps of:

performing a processing of dissolving;
performing a processing of casting;
performing a processing of hot rolling;
performing a processing of facing;
performing a processing of cold rolling;
performing a processing of a solution annealed crystallization heat treatment;
performing a processing of quick cooling (hereinafter, it is called "quenching" as well);
performing a processing of an aging heat treatment; and
performing a processing of final cold rolling.

Moreover, it may be available for the aging heat treatment and the final cold rolling to be performed in a reversed order. And then after performing the final cold rolling a low temperature annealing is designed to be performed as required. Further, in order to obtain the copper alloy material for electric/electronic components in accordance with the present invention the solution annealed crystallization heat treatment is designed to be performed at a temperature between 700°C and 1000°C which is before performing the final cold rolling. And then the ground is because that the objective is to perform the solution heat treatment as sufficiently of the above mentioned elements, such as Ni or Co or the like, and that it is necessary to perform with the temperature of higher than or equal to 700°C in order to perform the recrystallization treatment, in the meantime however, that in a case where the temperature becomes higher than 1000°C it is not able to perform the heating as easily from a manufacturing point of view, because the temperature becomes close to a neighborhood of a melting point of copper, and hence because that a problem becomes to be occurred, such as a partial fusion of a material or a distortion of a shape or the like. And then therefore if the temperature is between 800°C and 950°C as preferred it becomes able to perform both of the solution heat treatment and the recrystallization treatment as sufficiently, and it is the temperature as well by which it becomes able to perform a production as stably from the manufacturing point of view. And then by making use of the solution annealed recrystallization heat treatment at this temperature it becomes able to determine the grain size in the copper alloy material.

Still further, in accordance with the present invention it is desirable to perform the quick cooling with having the cooling rate to be faster than or equal to 20°C per second from this temperature of the solution annealed recrystallization heat treatment. In the meantime however, if it is not able to perform this quick cooling there may be an occurrence of a precipitation of an element which is solution heated at the above mentioned high temperature. And then such a particle (chemical compound) which occurs the precipitation at the period of performing this cooling is an incommensurate or a noncoherent precipitate which will not contribute to the strength. Still further, such a particle becomes to contribute as a site for generating a core at a time when a commensurate or coherent precipitate is to be formed at the following aging heat treatment. And then due to this particle the precipitation at a corresponding part becomes to be progressed. And hence the properties becomes to be effected as negatively. Still further, it is further preferable for the cooling rate to be faster than or equal to 100°C per second, on the contrary however, in a case where the rate is too fast there becomes to be occurred a distortion of a material due to a phenomenon of expansion and contraction of the material. And then therefore the rate is set up to be approximately 200°C per second at the fastest.

Still further, regarding this cooling rate a desirable rate for the Ni-Si system is different from that for the Co-Si system and from that for the Ni-Co-Si system. For example, in a case of the Ni-Si system the desirable rate is faster than or equal to 100°C per second, and in the meantime, in a case of the Ni-Co-Si system the desirable rate is faster than or equal to 120°C per second, and in the meantime, in a case of the Co-Si system the desirable rate is faster than or equal to 150°C per second, respectively.

Furthermore, this cooling rate is defined here to be an average rate to 300°C from the temperature for the solution annealed recrystallization heat treatment as the high temperature. In the meantime however, at a temperature which is lower than or equal to 300°C it is not able to obtain an occurrence of a variation as largely in the texture. And then therefore the cooling rate is set up to this temperature.

Examples

The present invention will be described in detailed below, with being based on Examples. However, the present invention will not be limited to any one of those.

(Example 1)

Here, each of the copper alloys which is made use for the corresponding Examples (the present invention examples and the comparative examples) in accordance with the present invention is formed of an alloy (the present invention examples No. 1 to 30 and the comparative examples No. 1 to 30) which contains a component that is shown in the following Table 1 and the Table 2 respectively, and contains a remaining portion which is formed of Cu and an unavoidable impurity, respectively. Moreover, each of those alloys is dissolved by making use of a high frequency melting furnace, and then thereafter each of these is casted with a cooling rate between 10°C per second and 30°C per second to obtain an ingot which has a dimension of a thickness of 30 mm and a width of 120 mm and a length of 150 mm, respectively.

Next, each of those obtained ingots is maintained at a temperature between 930°C and 970°C with an amount of time between 0.5 hour and 1 hour, and then the hot rolling is performed thereafter to perform a production of a hot rolled sheet which has a thickness (t) that equals to twelve millimeters then to be equal to ten millimeters by performing a facing 1 millimeter off for each of the faces, and then thereafter by performing a cold rolling the same is finished to have the (t) to be equal to 0.25 mm.

Next, a solution annealed recrystallization heat treatment is performed for the sheet material which has the (t) that equals to 0.25 mm at a temperature between 700°C and 1000°C with an amount of time between ten seconds and thirty seconds. And then immediately thereafter a quenching is performed with a variety of the cooling rates that are individually shown in the Tables. Moreover, an aging heat treatment is performed at a temperature between 450°C and 550°C with an amount of time between 1 hour and 4 hours. And then thereafter a final cold rolling is performed as a finishing rolling with a processing rate (draft) between five percent and thirty percent. And thus the copper alloy material is produced. Further, a low temperature annealing is performed as required at a temperature between 300°C and 450°C after performing the finishing rolling. And then the characteristics is examined for each of the material samples.

Here, various kinds of characteristic evaluations are performed for each of these obtained copper alloy materials as a sample material, that will be described in detail below. And then an obtained result is shown in the Table 1 and the Table 2, respectively. Moreover, in each of the Tables the "temperature of the solution annealed recrystallization heat treatment" is abbreviated to be a "heat treatment temperature".

a. Hardness:

A sheet material is cut out from a sample material to have a dimension of ten millimeters times twenty millimeters, and then the same is filled with a resin by which it becomes able to perform a polishing in a vertical direction to a rolling direction. And then thereafter the same is finished to have a mirror face by performing a mechanical polishing and then performing a wet polishing. And then thereafter a measurement is performed by making use of a Vickers hardness tester for a cross section which is vertical to the rolling direction with a load of 2 Newtons and with 5 times of the number of the measurement for approximately a central part of the cross section, and then an average value is evaluated. Moreover, regarding the Vickers hardness tester the type HM-215 is made use which is produced by AKASHI of Mitutoyo Corporation.

b. Bending workability:

Each of the sample sheet materials is cut out as vertical to the rolling direction with having a dimension of a width of ten millimeters and a length of twenty-five millimeters (a thickness is equivalent to the corresponding sample sheet material), and then a test piece is produced, that is shown in FIG. 1. And then thereafter a (W) bending (Bad-way bending) is performed with a bending angle of 90 degrees for this test piece with an axis of the bending to be parallel to the rolling direction to have three types of bend radius (R) to be equal to zero millimeter, 0.2 millimeter and 0.4 millimeter respectively, that is shown in FIG. 2. And then there is examined regarding a crack whether or not exist, by performing a visual observation with making use of an optical microscope with a magnification of fifty times regarding a crack whether or not exist at a bended part, and by making use of a scanning electron microscope (an SEM) for a part to be performed the bend working. Here, the "GOOD" indicates no crack in the Table 1 and in the Table 2 respectively, and in the meantime, the "NO GOOD" indicates an occurrence of a crack. Moreover, this test is performed with being based on the JBMA-T307 (1999) in accordance with the technical standards of Copper Elongation Society of Japan. Further, the measurement of the grain size for the evaluation of "NO GOOD" is designed to be performed by performing a measurement of a grain size at a vicinity of a crack.

c. Grain size:

Regarding a grain size (GS: $\mu$m) before performing a bend working a cross section of a sample sheet material (the sheet before performing the bending test which is shown in FIG. 1) which is vertical to the rolling direction is finished to have a mirror face by the wet polishing and then by a buff polishing. And then thereafter the polished face is etched for several seconds with making use of a solution in which a ratio between a chromic acid and an aqua is one by one. And then thereafter a photograph is taken by making use of the optical microscope with the magnification of 200 to 400 times or by making use of a secondary electron image of the scanning electron microscope (SEM) with the magnification of 500 to 2000 times. And then the thickness (a) and the width (b) of the grains are measured with approximately 50 to 100 pieces regarding the grain size on the cross section, which is pursuant to the method of cutting in accordance with the JIS H0501. And then an average grain size and an average aspect ratio are evaluated by making use of each of those values, respectively. (Refer to the paragraph number [0010].)
Moreover, regarding a crystalline grains size after performing the bend working a test piece, that is performed the bend working which is similar to the description in the term of the "bend workability" of the above described (b.), is filled with a resin. And then the same is finished to have a mirror face by performing the wet polishing and then by performing the buff polishing that are similar to each of the above descriptions. And then thereafter the polished face is etched for several seconds with making use of a solution in which a ratio between a chromic acid and an aqua is one by one. And then thereafter a photograph is taken by making use of the optical microscope with the magnification between 200 times and 400 times or by making use of the secondary electron image of the scanning electron microscope (SEM) with the magnification between 500 times and 2000 times. And then the thickness (a') and the width (b') of the grains, that exist within a range of approximately 50 $\mu$m from a surface layer at a bended upper part, are measured with the number approximately between ten pieces and twenty pieces regarding the grain size on the cross section, which is pursuant to the method of cutting in accordance with the JIS H0501. And then an average aspect ratio is evaluated by making use of each of those values, respectively. (Refer to the paragraph number [0010].)
Further, in the case of the present invention examples No. 6, 7, 13, 14 and of the (R) is equal to zero it is not able to perform the measurement of the (a') and of the (b') because a crack is occurred at each of the surface layers (surface at each of the bended parts), respectively.

d. Cooling rate:

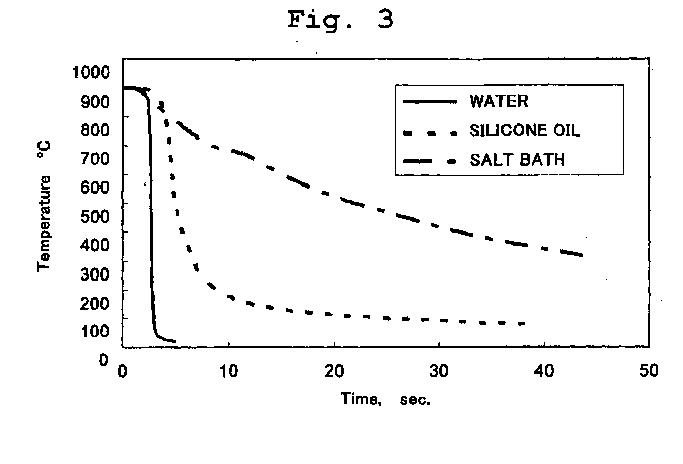

An adjustment of the cooling rate is performed by changing the type of the liquid coolants and by changing the quantity of each of the liquid coolants in a bath which is for performing the quenching, respectively. Moreover, the liquid coolants that are prepared are the three types of an aqua (a water temperature between 20°C and 30°C), a silicone oil (a liquid temperature between 20°C and 30°C) and a salt bath (a liquid temperature of 300°C, a nitrate salt is made use). Moreover, in the case of making use of the salt bath each of the sample materials is cooled down to a normal temperature by making use of a water bath as a usage of the cooling from lower than or equal to 300°C (a secondary cooling) . Here, one example of the cooling rate with making use of each of the baths is shown in FIG. 3. Further, this data is a result of which a measurement is performed for a test piece (dimensions (mm): 50 times 150 times 0.2) with installing a thermoelectric couple.
Still further, each of these examples are the case of which a quantity of each of the liquid coolants is approximately five liters. And then the cooling rate becomes to be faster in an order of the aqua > the silicone oil > the salt bath. Furthermore, this curve becomes to be gentle in the case where the quantity of each of the liquid coolants is reduced, respectively. And in the meantime, in accordance with the present test it is not able to obtain any improvement of the cooling rate as remarkably even in the case where the quantity of each of the liquid coolants is increased, respectively.

(Table 1)

(TABLE 1: PRESENT INVENTION EXAMPLES)

| No. | COMPOSITION(mass%) | | | | HEAT TREATMENT TEMPERATURE | COOLING RATE | Hv | BEFORE PERFORMING A BEND WORKING | | R=0 | | R=0.2 | | R=0.4 | |
|---|---|---|---|---|---|---|---|---|---|---|---|---|---|---|---|
| | Ni | Co | Si | THE OTHERS | (°C) | (°C/sec) | | GS (μm) | a/b | EVALUATION | FORMULA (1) | EVALUATION | FORMULA (1) | EVALUATION | FORMULA (1) |
| 1 | 1.2 | 1.4 | 0.65 | | 950 | 110 | 22B | 17 | 1.0 | GOOD | 12.0 | GOOD | 3.7 | GOOD | 3.3 |
| 2 | 1.6 | 1 | 0.65 | | 890 | 110 | 228 | 22 | 0.9 | GOOD | 11.4 | GOOD | 3.5 | GOOD | 3.4 |
| 3 | 2 | 0.6 | 0.65 | | 830 | 110 | 226 | 21 | 0.9 | GOOD | 11.4 | GOOD | 3.9 | GOOD | 2.9 |
| 4 | 2.5 | | 0.63 | | 750 | 110 | 223 | 18 | 1.0 | GOOD | 11.4 | GOOD | 3.9 | GOOD | 3.3 |
| 5 | 3.1 | | 0.78 | | 800 | 110 | 271 | 16 | 0.8 | GOOD | 11.3 | GOOD | 4.2 | GOOD | 3.0 |
| 6 | 3.7 | | 0.93 | | 850 | 110 | 299 | 23 | 1.0 | NO GOOD | --- | GOOD | 4.1 | GOOD | 2.7 |
| 7 | 4.1 | | 1.03 | | 875 | 110 | 312 | 23 | 0.9 | NO GOOD | --- | GOOD | 3.5 | GOOD | 3.1 |
| 8 | 1.2 | 1.4 | | 0.63 Zn=0.5, Mg=0.1 | 950 | 150 | 228 | 20 | 0.8 | GOOD | 11.5 | GOOD | 4.1 | GOOD | 2.5 |
| 9 | 1.6 | 1 | 0.63 | Sn=0.1 | 900 | 150 | 234 | 26 | 0.8 | GOOD | 11.9 | GOOD | 3A | GOOD | 2.7 |
| 10 | 2 | 0.6 | | 0.63 Sn-0.1, Cr=0.1 | 840 | 150 | 230 | 24 | 1.0 | GOOD | 11.2 | GOOD | 3.9 | GOOD | 3.5 |
| 11 | 1 2.6 | | 0.83 | Sn=0.15, Zn=0.5, Mg=0.1 | 750 | 150 | 229 | 14 | 0.9 | GOOD | 11.9 | GOOD | 3.7 | GOOD | 2.5 |
| 12 | 3 | | 0.73 | Sn=0.15, Zn=0.5, Mg=0.15 | 800 | 150 | 261 | 15 | 1.0 | GOOD | 11.5 | GOOD | 4.2 | GOOD | 2.5 |
| 13 | 3 3.8 | | 0.93 | Sn=0.15, Zn=0.5, Mg=0.1, Cr=0.1 | 850 | 160 | 295 | 23 | 0.9 | NO GOOD | ... | GOOD | 3.4 | GOOD | 3.5 |
| 14 | 4 | | 0.98 | Sn=0.15, Zn=0.5, Mg=0.1, Cr=0.1 | 875 | 150 | 321 | 14 | 1.0 | NO GOOD | ... | GOOD | 3.3 | GOOD | 2.9 |

(continued)

| No. | COMPOSITION(mass%) | | | | HEAT TREATMENT TEMPERATURE | COOLING RATE | Hv | BEFORE PERFORMING A BEND WORKING | | R=0 | | R=0.2 | | R=0.4 | |
|---|---|---|---|---|---|---|---|---|---|---|---|---|---|---|---|
| | Ni | Co | Si | THE OTHERS | (°C) | (°C/sec) | | GS (μm) | a/b | EVALUATION | FORMULA (1) | EVALUATION | FORMULA (1) | EVALUATION | FORMULA (1) |
| 15 | 0.5 | 0.5 | 0.24 | | 820 | 130 | 189 | 20 | 0.8 | GOOD | 11.5 | GOOD | 4.1 | GOOD | 2.9 |
| 18 | 0.5 | 0.8 | 0.32 | | 865 | 130 | 242 | 21 | 0.9 | GOOD | 12.0 | GOOD | 3.8 | GOOD | 2.7 |
| 17 | 0.3 | 1 | 0.32 | | 890 | 130 | 238 | 22 | 1.0 | GOOD | 11.4 | GOOD | 3.9 | GOOD | 2.7 |
| 18 | 0.1 | 1.2 | 0.32 | | 920 | 130 | 245 | 19 | 0.9 | GOOD | 11.6 | GOOD | 3.8 | GOOD | 2.8 |
| 19 | | 0.5 | 0.12 | | 820 | 130 | 195 | 23 | 0.8 | GOOD | 11.8 | GOOD | 3.3 | GOOD | 2.9 |
| 20 | | 0.8 | 0.20 | | 875 | 130 | 218 | 13 | 0.9 | GOOD | 11.7 | GOOD | 4.0 | GOOD | 2.9 |
| 21 | | 1.1 | 0.27 | | 910 | 130 | 225 | 22 | 0.9 | GOOD | 11.7 | GOOD | 3.8 | GOOD | 3.1 |
| 22 | 0.6 | 0.53 | | 0.26 Sn=0.15, Cr=0.1 | 832 | 110 | 117 | 20 | 0.9 | GOOD | 12.0 | GOOD | 3.7 | GOOD | 3.4 |
| 23 | 0.5 | 0.82 | | 0.34 Zn=0.5, Mg=0.2 | 875 | 110 | 175 | 24 | 0.9 | GOOD | 11.8 | GOOD | 3.7 | GOOD | 3.0 |
| 24 | 0.4 | 1.02 | 0.34 | Sn=0.25, Zn=0.5, Mg=0.05 | 900 | 110 | 225 | 19 | 0.9 | GOOD | 12.1 | GOOD | 3.3 | GOOD | 3.0 |
| 25 | 0.1 | 1.29 | 0.33 | Sn=0.25, Zn=0.15, Mg=0.1 | 925 | 110 | 250 | 22 | 0.9 | NO GOOD | --- | GOOD | 3.8 | GOOD | 3.3 |

(continued)

| No. | COMPOSITION(mass%) | | | | HEAT TREATMENT TEMPERATURE | COOLING RATE | Hv | BEFORE PERFORMING A BEND WORKING | | R=0 | | R=0.2 | | R=0.4 | |
|---|---|---|---|---|---|---|---|---|---|---|---|---|---|---|---|
| | Ni | Co | Si | THE OTHERS | (°C) | (°C/sec) | | GS (μm) | a/b | EVALUATION | FORMULA (1) | EVALUATION | FORMULA (1) | EVALUATION | FORMULA (1) |
| 26 | | 0.55 | | 0.14 Sn=0.12, Zn=0.25, Mg=0.15, Cr=0.05 | 825 | 110 | 183 | 26 | 0.8 | GOOD | 11.8 | GOOD | 4.2 | GOOD | 3.3 |
| 27 | | 0.84 | 0.22 | Sn=0.15, Zn=0.75, Mg=0.1, Cr=0.2 | 875 | 110 | 195 | 25 | 0.9 | GOOD | 11.9 | GOOD | 3.9 | GOOD | 3.4 |
| 28 | | 1.13 | 0.28 | Sn=0.05, Zn=0.5, Mg=0.2 | 920 | 130 | 220 | 13 | 1.0 | GOOD | 11.2 | GOOD | 4.0 | GOOD | 3.5 |
| 29 | 1.0 | 1.20 | 0.54 | Fe=0.15, Zn=0.2 | 920 | 130 | 203 | 18 | 1.0 | GOOD | 11.7 | GOOD | 3.8 | GOOD | 3.3 |
| 30 | 0.3 | 1.5 | 0.44 | Fe=0.1, Ti=0.5, Zr=0.1 | 950 | 130 | 180 | 25 | 1.0 | GOOD | 11.2 | GOOD | 4.0 | GOOD | 3.1 |

(Table 2) (TABLE 2: COMPARATIVE EXAMPLES)

| No. | COMPOSITIONC (mass%) | | | | HEART TREATMENT TEMPERATURE (°C) | COOLING RATE (°C/sec) | Hv | BEFORE PERFORMING A BEND WORKING | | R=0 | | R=0.2 | | R=0.4 | |
|---|---|---|---|---|---|---|---|---|---|---|---|---|---|---|---|
| | Ni | Co | si | THE OTHERS | | | | GS (μm) | a/b | EVALUATION | FORMULA (1) | EVALUATION | FORMULA (1) | EVALUATION | FORMULA (1) |
| 1 | 1.2 | 1.4 | 0.65 | | 950 | 80 | 208 | 14 | 0.9 | NO GOOD | 16.2 | GOOD | 4.0 | GOOD | 3.1 |
| 2 | 1.6 | 1 | 0.65 | | 890 | 80 | 216 | 20 | 0.9 | NO GOOD | 16.5 | GOOD | 3.6 | GOOD | 3.2 |
| 3 | 2 | 0.6 | 0.65 | | 830 | 80 | 217 | 20 | 1.0 | NO GOOD | 17.3 | GOOD | 3.5 | GOOD | 3.2 |
| 4 | 2.5 | | 0.63 | | 750 | 80 | 211 | 20 | 1.0 | NO GOOD | 17.6 | GOOD | 3.8 | GOOD | 3.0 |
| 5 | 3.1 | | 0.78 | | 800 | 80 | 261 | 13 | 1.0 | NO GOOD | 16.7 | NO GOOD | 15.8 | GOOD | 2.6 |
| 6 | 3.7 | | 0.93 | | 850 | 80 | 281 | 17 | 0.9 | NO GOOD | 18.1 | NO GOOD | 17.0 | GOOD | 2.6 |
| 7 | 4.1 | | 1.03 | | 875 | 80 | 311 | 15 | 0.9 | NO GOOD | 17.7 | NO GOOD | 17.8 | GOOD | 2.6 |
| 8 | 1.2 | 1.4 | 0.63 | Zn=0.5, Mg=0.1 | 950 | 90 | 218 | 20 | 0.8 | NO GOOD | 17.1 | GOOD | 4.1 | GOOD | 3.5 |
| 9 | 1.6 | 1 | 0.63 | Sn=0.1 | 900 | 90 | 218 | 16 | 0.6 | NO GOOD | 18,8 | GOOD | 3.8 | GOOD | 2.6 |
| 10 | 2 | 0.5 | 0.63 | Sn=0.1, Cr=0.1 | 840 | 90 | 218 | 24 | 1.0 | NO GOOD | 16.8 | GOOD | 3.8 | GOOD | 3.1 |
| 11 | 2.6 | | 0.63 | Sn=0.15, Zn=0.5, Mg=0.1 | 750 | 90 | 217 | 19 | 0.9 | NO GOOD | 17.5 | GOOD | 3.4 | GOOD | 3.3 |
| 12 | 3 | | 0.73 | Sn=0.15, Zn=0.5. Mg=0.15 | 800 | 90 | 280 | 16 | 0.9 | NO GOOD | 17.6 | GOOD | 3.5 | GOOD | 2.9 |
| 13 | 3.6 | | 0.93 | Sn=0.15, Zn=0.5, Mg=0.1, Cr=0.1 | 850 | 90 | 291 | 19 | 1.0 | NO GOOD | 17.7 | NO GOOD | 17.6 | GOOD | 3.4 |

(continued)

| No. | COMPOSITIONC (mass%) | | | | HEART TREATMENT TEMPERATURE (°C) | COOLING RATE (°C/sec) | Hv | BEFORE PERFORMINGA BEND WORKING | | R=0 | | R=0.2 | | R=0.4 | |
|---|---|---|---|---|---|---|---|---|---|---|---|---|---|---|---|
| | Ni | Co | si | THE OTHERS | | | | GS (μm) | a/b | EVALUATION | FORMULA (1) | EVALUATION | FORMULA (1) | EVALUATION | FORMULA (1) |
| 14 | 4 | | 0.98 | Sn=0.15, Zn=0.5, Mg=0.1, Cr=0.1 | 875 | 90 | 305 | 12 | 0.8 | NO GOOD | 17.7 | NO GOOD | 17.3 | GOOD | 2.9 |
| 15 | 0.5 | 0.5 | 0.24 | | 820 | 70 | 188 | 10 | 0.8 | NO GOOD | 17.0 | GOOD | 3.6 | GOOD | 3.1 |
| 18 | 0.5 | 0.8 | 0.32 | | 885 | 70 | 237 | 22 | 0.8 | NO GOOD | 18.0 | GOOD | 4.1 | GOOD | 27 |
| 17 | 0.3 | 1 | 0.32 | | 890 | 70 | 217 | 23 | 0.9 | NO GOOD | 17.7 | GOOD | 42 | GOOD | 3.4 |
| 18 | 0.1 | 12 | 0.32 | | 920 | 70 | 241 | 15 | 0.9 | NO GOOD | 17.0 | GOOD | 4.0 | GOOD | 3.0 |
| 19 | | 0.5 | 0.12 | | 820 | 70 | 173 | 20 | 1.0 | NO GOOD | 17.3 | GOOD | 3.5 | GOOD | 3.2 |
| 20 | | 0.8 | 0.20 | | 875 | 70 | 211 | 22 | 0.9 | NO GOOD | 16.9 | GOOD | 3.6 | GOOD | 3.1 |
| 21 | | 1.1 | 0.27 | | 910 | 70 | 219 | 12 | 0.8 | NO GOOD | 17.7 | GOOD | 4.1 | GOOD | 2.7 |
| 22 | 0.6 | 0.54 | 0.28 | Sn=0.15, Cr=0.1 | 827 | 40 | 187 | 23 | 0.9 | NO GOOD | 17.9 | GOOD | 3.4 | GOOD | 3.2 |
| 23 | 0.6 | 0.88 | 0.35 | Zn=0.5, Mg=0.2 | 875 | 40 | 158 | 25 | 0.9 | NO GOOD | 17.7 | GOOD | 3.9 | GOOD | 2.9 |
| 24 | 0.3 | 1.03 | 0.33 | Sn=0.25, Zn=0.5, Mg=0.05 | 900 | 40 | 220 | 17 | 0.9 | NO GOOD | 17.5 | GOOD | 3.8 | GOOD | 3.2 |
| 25 | 0.1 | 1.25 | 0.33 | Sn=0.25, Zn=0.15, Mg=0.1 | 925 | 40 | 247 | 23 | 1.0 | NO GOOD | 17.1 | NO GOOD | 16.5 | GOOD | 3.1 |

(continued)

| No. | COMPOSITION C (mass%) | | | | HEART TREATMENT TEMPERATURE (°C) | COOLING RATE (°C/sec) | Hv | BEFORE PERFORMING A BEND WORKING | | R=0 | | R=0.2 | | R=0.4 | |
|---|---|---|---|---|---|---|---|---|---|---|---|---|---|---|---|
| | Ni | Co | si | THE OTHERS | | | | GS (μm) | a/b | EVALUATION | FORMULA (1) | EVALUATION | FORMULA (1) | EVALUATION | FORMULA (1) |
| 26 | | 0.60 | 0.15 | Sn=0.12, Zn=0.25, Mg=0.15. Cr=0.05 | 825 | 40 | 170 | 22 | 0.9 | NO GOOD | 18.1 | GOOD | 3.5 | GOOD | 3.2 |
| 27 | | 0.85 | 0.21 | Sn=0.15, Zn=0.75, Mg=0.1, Cr=0.2 | 875 | 40 | 187 | 12 | 0.9 | NO GOOD | 17.3 | GOOD | 3.6 | GOOD | 2.6 |
| 28 | | 1.14 | 0.28 | Sn=0.05, Zn=0.5, Mg=0.2 | 920 | 60 | 218 | 24 | 0.9 | NO GOOD | 17.0 | GOOD | 3.4 | GOOD | 3.2 |
| 29 | 1.0 | 1.20 | 0.54 | Fe=0.15, Zn=0.2 | 920 | 60 | 197 | 20 | 1.0 | NO GOOD | 17.7 | GOOD | 4.2 | GOOD | 3.2 |
| 30 | 0.3 | 1.5 | 0.44 | Fe=0.1, Ti=0.5, Zr=0.1 | 950 | 60 | 171 | 27 | 0.9 | NO GOOD | 17.7 | GOOD | 3.6 | GOOD | 2.8 |

Each of the materials in accordance with the comparative examples has the bending workability to be worsened because each thereof does not satisfy the Formula (1) which is specified in accordance with the present invention, in spite of which each thereof has the hardness to be as lower with comparing to each of the present invention examples. And hence each thereof is inferior in the strength (the hardness) and in the bending workability, respectively. That is because it may be considered that each of the grains will not occur a homogeneous distortion regarding a size at the time of performing the bend working, but that only a particular grain will occur a distortion in size, and then that a grain boundary becomes to be destroyed.

Industrial Applicability

The copper alloy material for electric/electronic components in accordance with the present invention becomes to be made use as desirable for such as a connector or a terminal material or the like for a usage of an electric apparatus and of an electronic equipment, and also for a connector or a terminal material for such as to be mounted on a motor vehicle or the like, and for electric/electronic components, such as a relay, a switch, lead frame, or the like.

And thus the present invention is described above with the embodiment, however, the present invention will not to be limited to every detail of the description as far as a designation in particular, and then it should be interpreted widely without departing from the spirit and scope of the present invention as disclosed in the attached claims.

Furthermore, the present invention claims the priority based on Japanese Patent Application Publication No. 2008-029778, that is patent applied in Japan on the 8th day of February, 2008, and the entire contents of which are expressly incorporated herein by reference as a part of the description of the present specification.

**Claims**

1. A copper alloy material for electric/electronic components,
   wherein a average grain size of 1 to 50 $\mu$m that is designated by $((a + b) / 2)$ in which a thickness of a grain is defined to be (a) and a width thereof is defined to be (b) which is on a cross section that is vertical to a rolling direction,
   an aspect ratio $(a / b)$ thereof is between 0.5 and 1.0,
   an aspect ratio $(a / b)$ of a grain before performing a bend working and an aspect ratio $(a' / b')$ of which a grain is effected by a tensile stress after performing a bend working of 90 degrees satisfy a following (Formula 1):

$$2 \leq (a + b) / (a' / b') \leq 15 \quad (Formula\ 1),$$

   and
   said copper alloy material has a bending workability to be excellent.

2. The copper alloy material for electric/electronic components according to claim 1,
   wherein a Vickers hardness (Hv) on a cross section is between 180 and 350, which is vertical to said rolling direction before performing said bend working, and
   said copper alloy material has a bending workability to be excellent.

3. The copper alloy material for electric/electronic components according to claim 1 or 2, comprising:

   Ni and/or Co between 1.0 mass% and 4.5 mass%, respectively;
   Si between 0.2 mass% and 1.2 mass%; and
   a remaining portion which is formed of Cu and an unavoidable impurity.

4. The copper alloy material for electric/electronic components according to claim 3,
   wherein said copper alloy material further comprises at least one nature between 0.005 mass% and 1.0 mass%, which is selected from a group that is comprised of Sn, Zn, Cr and Mg.

5. The copper alloy material for electric/electronic components according to any of claims 1 to 4,
   wherein it becomes able to perform a solution annealed recrystallization heat treatment with a temperature between 700°C and 1000°C before performing a final rolling, and
   it becomes able to perform a quick cooling with a cooling rate of faster than or equal to 100°C per second.

# Fig. 1

SHEET BEFORE
BENDING TEST

ROLLING
DIRECTION

BENDING
TEST
PIECE

1

1

a

b

# Fig. 2

BENDING
TEST
PIECE

BENDING OF
90 DEGREES

2

2

a'

b'

## Fig. 3

## INTERNATIONAL SEARCH REPORT

| | International application No. |
|---|---|
| | PCT/JP2009/052082 |

A. CLASSIFICATION OF SUBJECT MATTER
*C22C9/06*(2006.01)i, *C22F1/08*(2006.01)i, *H01B1/02*(2006.01)i, *C22F1/00*
(2006.01)n, *H01L23/50*(2006.01)n

According to International Patent Classification (IPC) or to both national classification and IPC

B. FIELDS SEARCHED

Minimum documentation searched (classification system followed by classification symbols)
C22C9/06, C22F1/08, H01B1/02, C22F1/00, H01L23/50

Documentation searched other than minimum documentation to the extent that such documents are included in the fields searched
Jitsuyo Shinan Koho          1922-1996   Jitsuyo Shinan Toroku Koho   1996-2009
Kokai Jitsuyo Shinan Koho    1971-2009   Toroku Jitsuyo Shinan Koho   1994-2009

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2006-219733 A (Kobe Steel, Ltd.), 24 August, 2006 (24.08.06), Claims 1 to 9; Par. Nos. [0014], [0017] to [0023] (Family: none) | 1-5 |
| X<br>A | JP 4006467 B1 (Kobe Steel, Ltd.), 31 August, 2007 (31.08.07), Claims 1 to 5; Par. Nos. [0082] to [0089], [0093] to [0127] & WO 2007/138956 A1 | 1,2,4,5<br>3 |
| A | JP 2008-24999 A (Dowa Holdings Co., Ltd.), 07 February, 2008 (07.02.08), Claims 1, 2; Par. Nos. [0027], [0028], [0034], [0040] to [0047] (Family: none) | 1-5 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 15 April, 2009 (15.04.09) | 28 April, 2009 (28.04.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

| International application No. |
| --- |
| PCT/JP2009/052082 |

C (Continuation). DOCUMENTS CONSIDERED TO BE RELEVANT

| Category* | Citation of document, with indication, where appropriate, of the relevant passages | Relevant to claim No. |
| --- | --- | --- |
| A | JP 2006-9108 A (Nikko Metal Manufacturing Co., Ltd.), 12 January, 2006 (12.01.06), Claims 1 to 4; Par. Nos. [0017] to [0026] (Family: none) | 1-5 |
| A | JP 2007-270171 A (Dowa Holdings Co., Ltd.), 18 October, 2007 (18.10.07), Claims 1 to 7 (Family: none) | 1-5 |
| A | JP 9-20943 A (The Furukawa Electric Co., Ltd.), 21 January, 1997 (21.01.97), Claims 1 to 5 (Family: none) | 1-5 |
| A | JP 2002-38228 A (The Furukawa Electric Co., Ltd.), 06 February, 2002 (06.02.02), Claims 1, 2 & US 2002/0127133 A1 & US 2003/0165708 A1 & US 2005/0208323 A1 & EP 1325964 A1 & WO 2002/008479 A1 & DE 60131763 T & TW 0225519 B & CN 1366556 A | 1-5 |
| A | JP 2002-180161 A (The Furukawa Electric Co., Ltd.), 26 June, 2002 (26.06.02), Claims 1, 2 & US 2002/0119071 A1 & US 2004/0045640 A1 & DE 10147968 A & TW 0255860 B & KR 10-2002-0053702 A & CN 1358875 A | 1-5 |
| A | JP 5-279825 A (Mitsubishi Shindoh Co., Ltd.), 26 October, 1993 (26.10.93), Claims 1, 2 (Family: none) | 1-5 |
| A | JP 5-255779 A (The Furukawa Electric Co., Ltd.), 05 October, 1993 (05.10.93), Claims 1 to 4 (Family: none) | 1-5 |
| A | JP 6-17209 A (The Furukawa Electric Co., Ltd.), 25 January, 1994 (25.01.94), Claims 1, 2 (Family: none) | 1-5 |

Form PCT/ISA/210 (continuation of second sheet) (April 2007)

**EP 2 243 847 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002180161 A
- JP H11293367 B
- JP H10110228 B
- JP H03162553 B
- JP H05279825 B
- JP H11335756 B
- JP H07018356 B
- JP H03188247 B
- JP 2005089843 A
- JP 2008029778 A